(19) Europäisches Patentamt

European Patent Office

Office européen des brevets

(11) **EP 1 619 728 A1**

(12) **EUROPEAN PATENT APPLICATION**
published in accordance with Art. 158(3) EPC

(43) Date of publication:
**25.01.2006 Bulletin 2006/04**

(51) Int Cl.:
*H01L 31/072* (1990.01)    *H01L 31/032* (1990.01)

(21) Application number: **04726779.4**

(22) Date of filing: **09.04.2004**

(86) International application number:
**PCT/JP2004/005125**

(87) International publication number:
**WO 2004/090995 (21.10.2004 Gazette 2004/43)**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **09.04.2003 JP 2003105752**

(71) Applicant: **MATSUSHITA ELECTRIC INDUSTRIAL CO., LTD.**
**Kadoma-shi, Osaka 571-8501 (JP)**

(72) Inventors:
• **Satoh, Takuya**
  **614-8297 Kyoto (JP)**
• **Negami, Takayuki**
  **573-0164 Osaka (JP)**
• **Hashimoto, Yasuhiro**
  **630-0254 Nara (JP)**

(74) Representative: **Schwarzensteiner, Marie-Luise**
**Grape & Schwarzensteiner**
**Patentanwälte**
**Sebastiansplatz 7**
**80331 München (DE)**

(54) **SOLAR CELL**

(57)    A solar cell including a light-absorption layer of a compound semiconductor with a chalcopyrite crystal structure and having excellent characteristics such as conversion efficiency is provided. The solar cell includes a first electrode layer, a second electrode layer, a p-type semiconductor layer interposed between the first electrode layer and the second electrode layer, and an n-type semiconductor layer interposed between the p-type semiconductor layer and the second electrode layer. The p-type semiconductor layer includes a compound semiconductor containing a group Ib element, a group IIIb element and a group VI element and having a chalcopyrite structure. The bandgap of the p-type semiconductor layer increases from the n-type semiconductor layer side to the first electrode layer side monotonically. The bandgap of the p-type semiconductor layer on the main surface at the n-type semiconductor layer side is at least 1.08 eV, and the bandgap of the p-type semiconductor layer on the main surface at the first electrode layer side is at least 1.17 eV. In the p-type semiconductor layer, a first region at the n-type semiconductor layer side and a second region at the first electrode layer side are different from each other in bandgap increase rate in a direction of thickness of the p-type semiconductor layer.

FIG. 2A

**EP 1 619 728 A1**

**Description**

Technical Field

The present invention relates to a solar cell. More specifically, the present invention relates to a compound semiconductor solar cell including a compound semiconductor light-absorption layer.

Background Art

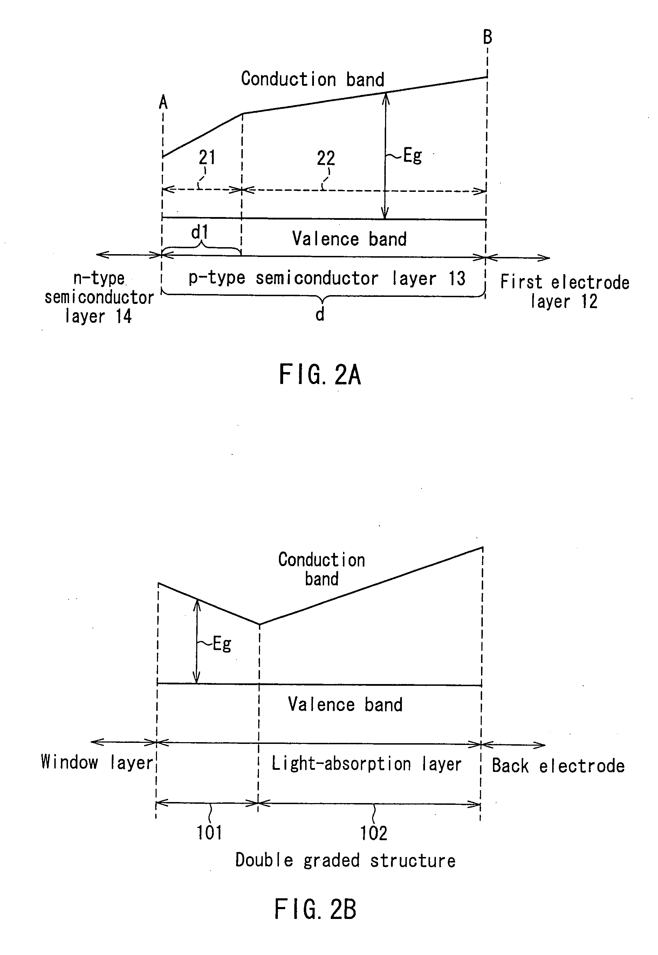

It has been known that a thin film solar cell, which includes a light-absorption layer of a compound semiconductor with a chalcopyrite structure such as Cu(In,Ga)Se$_2$ (hereinafter, this may be abbreviated as CIGS), exhibits excellent characteristics. It is known that particularly excellent conversion efficiency can be obtained when the light-absorption layer includes CIGS where a bandgap profile in a direction of thickness of the film has a two-staged configuration of a decrease region and an increase region. More specifically, such a solar cell includes a light-absorption layer having a so-called double graded structure where a bandgap decreases first from a window layer side to a back electrode side and subsequently increases. For example, such a solar cell is disclosed in 'A new approach to high-efficiency solar cells by band gap grading in Cu(In,Ga)Se$_2$ chalcopyrite semiconductors' by T. Dullweber, "Solar Energy Materials & Solar Cells", Vol. 67, p.145-150 (2001). A band profile of a light-absorption layer with the above-mentioned double graded structure is shown schematically in FIG. 2B. As shown in FIG. 2B, in the double graded structure, a bandgap Eg of the light-absorption layer decreases (a decrease region 101) from the window layer side to the back electrode side, and subsequently increases (an increase region 102).

The bandgap of CIGS can be controlled by increasing/decreasing the concentration of dissolved Ga or the like. For example, a CIGS film having a bandgap matching with solar spectra can be manufactured.

At present, there is a keen demand for a further improvement in the reliability and the characteristics (for example, conversion efficiency) of a solar cell including a compound semiconductor with a chalcopyrite structure. The present invention is intended to provide a solar cell that includes a light-absorption layer of the above-mentioned compound semiconductor and that has excellent characteristics such as conversion efficiency.

Disclosure of Invention

A solar cell of the present invention includes a first electrode layer, a second electrode layer, a p-type semiconductor layer interposed between the first electrode layer and the second electrode layer, and a n-type semiconductor layer interposed between the p-type semiconductor layer and the second electrode layer, wherein the p-type semiconductor layer includes a compound semiconductor that contains a group Ib element, a group IIIb element and a group VIb element and has a chalcopyrite structure; the p-type semiconductor layer has a bandgap that increases from the n-type semiconductor layer side to the first electrode layer side monotonically; the bandgap of the p-type semiconductor layer on the main surface at the n-type semiconductor layer side is at least 1.08 eV; the bandgap of the p-type semiconductor layer on the main surface at the first electrode layer side is at least 1.17 eV; and, in the p-type semiconductor layer, a first region at the n-type semiconductor layer side and a second region at the first electrode layer side are different from each other in a bandgap increase rate in a direction of thickness of the p-type semiconductor layer.

Brief Description of Drawings

FIG. 1 is a schematic cross-sectional view showing an example of a solar cell of the present invention.
FIG. 2A is a schematic view showing an example of a band profile of a light-absorption layer in a solar cell of the present invention.
FIG. 2B is a schematic view showing an example of a band profile of a light-absorption layer having a double graded structure in a conventional solar cell.
FIG. 3 is a schematic view showing an example of a change in an atom number ratio of Ga in a p-type semiconductor layer defined in an Example.
FIG. 4 is a schematic view for indicating an example of a band profile of a p-type semiconductor layer defined in an Example.
FIG. 5 is a graph showing results of Example 1.
FIG. 6 is a graph showing results of Example 2.

Description of the Invention

The following describes embodiments of the present invention, with reference to the drawings. In the following description of embodiments, the same reference numerals may be assigned to the same elements in order to avoid the duplication of explanation.

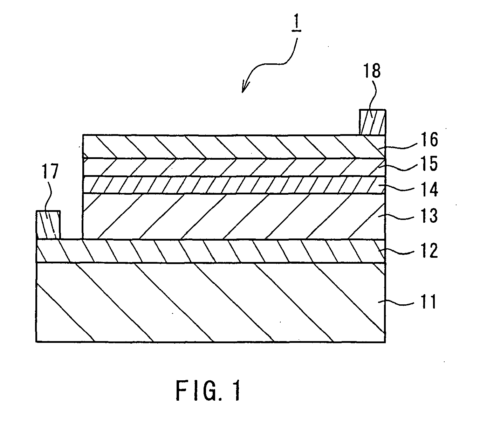

An example of a solar cell of the present invention is shown in FIG. 1. A solar cell 1 as shown in FIG. 1 includes a first electrode layer 12, a second electrode layer 16, a p-type semiconductor layer 13 interposed between the first electrode layer 12 and the second electrode layer 16, and n-type semiconductor layers 14 and 15 interposed between the second electrode layer 16 and the p-type semiconductor layer 13. The respective layers are formed on a substrate 11. In other words, the solar cell 1 as shown in FIG. 1 is formed by laminating the first electrode layer 12, the p-type semiconductor layer 13, the n-type semiconductor layers 14 and 15, and the second electrode layer 16 in this order when viewed from the substrate 11 side.

Here, the p-type semiconductor layer 13 is a light-absorption layer, and the solar cell 1 of the present invention generates photoelectromotive force with light entering from the second electrode layer 16 side. The thus generated photoelectromotive force is transmitted to the outside through an extraction electrode 17 that is electrically connected to the first electrode layer 12 and also an extraction electrode 18 that is electrically connected to the second electrode layer 16.

Though the solar cell 1 as shown in FIG. 1 includes two n-type semiconductor layers, a solar cell of the present invention does not necessarily include plural n-type semiconductor layers as long as it includes at least one n-type semiconductor layer that can form a p-n junction with the p-type semiconductor layer 13 as a light-absorption layer. In the solar cell 1 as shown in FIG. 1, the n-type semiconductor layers 14 and 15 are, for example, semiconductor layers functioning as window layers.

The p-type semiconductor layer 13 is arranged on (light incidence side of) the first electrode layer 12. The p-type semiconductor layer 13 includes a compound semiconductor that contains a group Ib element, a group IIIb element and a group VIb element and that has a crystal structure (chalcopyrite structure) similar to chalcopyrite. In this specification, the groups of elements are expressed in accordance with specifications of IUPAC (1970). According to the specifications of the IUPAC (1989), the group Ib element, the group IIIb element and the group VIb element respectively correspond to a group 11 element, a group 13 element and a group 16 element.

Here, Cu (copper) can be used for the group Ib element, for example. For the group IIIb element, for example, at least one element selected from the group consisting of In (indium), Ga (gallium) and A1 (aluminum) can be used. For the group VIb element, for example, at least one element selected from the group consisting of Se (selenium) and S (sulfur) can be used. Specifically, the p-type semiconductor layer 13 can be formed with, for example, $CuInSe_2$ (it may be abbreviated as CIS), $CuIn(Se,S)_2$, $Cu(In,Ga)Se_2$ (it may be abbreviated as CIGS), $Cu(Al,Ga)Se_2$, $Cu(In,Ga)(Se,S)_2$ and the like. The p-type semiconductor layer 13 has a thickness, for example, in a range of about 0.4 $\mu$m to about 3.5 $\mu$m.

In the solar cell 1 of the present invention, the bandgap of the p-type semiconductor layer 13 increases from the n-type semiconductor layer 14 side to the first electrode layer 12 side monotonically. In the p-type semiconductor layer 13, a first region at the n-type semiconductor layer 14 side and a second region at the first electrode layer 12 side are different from each other in a bandgap increase rate in a direction of thickness of the p-type semiconductor layer 13. A band profile of the p-type semiconductor layer 13 is shown in FIG. 2A. As shown in FIG. 2A, the p-type semiconductor layer 13 includes a first region 21 at the n-type semiconductor layer side and a second region 22 at the first electrode layer 12 side. The bandgap increase rate in the first region 21 and the bandgap increase rate in the second region 22 are different from each other.

In the p-type semiconductor layer 13, the bandgap on the main surface at the n-type semiconductor layer 14 side (a main surface corresponding to the surface A as shown in FIG. 2A) is at least 1.08 eV, and the bandgap on the main surface at the first electrode layer 12 side (a main surface corresponding to the surface B as shown in FIG. 2A) is at least 1.17 eV

The thus configured solar cell 1 includes a light-absorption layer of a compound semiconductor with a chalcopyrite structure and the solar cell 1 has excellent characteristics such as conversion efficiency.

In a solar cell having a first electrode layer 12, a p-type semiconductor layer 13 and a n-type semiconductor layer 14 arranged adjacent to each other as in the solar cell 1 in FIG. 1, the bandgap of a part of the p-type semiconductor layer 13 adjacent to the n-type semiconductor layer 14 can be at least 1.08 eV, and the bandgap of a part of the p-type semiconductor layer 13 adjacent to the first electrode layer 12 can be at least 1.17 eV

In the solar cell 1 of the present invention, there is no specific upper limit for each of the bandgaps. The bandgap of the p-type semiconductor layer 13 on the main surface at the n-type semiconductor layer 14 side (a bandgap of the p-type semiconductor layer 13 on the surface A in FIG. 2A) has an upper limit of 1.4 eV (preferably, 1.26 eV) for example, and the p-type semiconductor layer 13 on the main surface at the first electrode layer 12 side (a bandgap of the p-type semiconductor layer 13 on the surface B in FIG. 2A) has an upper limit of 1.6 eV (preferably, 1.54 eV) for example.

In the solar cell 1 of the present invention, the bandgap of the p-type semiconductor layer 13 on the main surface at the n-type semiconductor layer 14 side can be at least 1.2 eV Furthermore, in the solar cell 1 of the present invention, the bandgap of the p-type semiconductor layer 13 on the main surface at the first electrode layer 12 side can be at least 1.3 eV It is particularly preferable that the bandgap of the p-type semiconductor layer 13 on the main surface at the n-type semiconductor layer 14 side is at least 1.2 eV and the bandgap of the p-type semiconductor layer 13 on the main surface at the first electrode layer 12 side is at least 1.3 eV, thereby providing a solar cell whose characteristics such as conversion efficiency are excellent.

It is required that the bandgap increase rate in the first region 21 and the bandgap increase rate in the second region 22 be different from each other. It is particularly preferable that the bandgap increase rate in the second region 22 at the first electrode layer 12 side be smaller than the bandgap increase rate in the first region 21 at the n-type semiconductor layer 14 side, thereby providing a solar cell whose characteristics such as conversion efficiency are excellent. For example, in the band profile as shown in FIG. 2A, the bandgap increase rate in the second region 22 is smaller than the bandgap increase rate in the first region 21.

There is no particular limitation on the thickness of the first region 21 (d1 in FIG. 2A) with respect to the thickness of the p-type semiconductor layer 13 (d in FIG. 2A). The thickness of the first region 21 can be in a range of 5% to 40% of the thickness of the p-type semiconductor layer 13, for example.

A difference between the bandgap of the p-type semiconductor layer 13 on the main surface at the n-type semiconductor layer 14 side and the bandgap of the p-type semiconductor layer 13 on the main surface at the first electrode layer 12 side is at least 0.09 eV It is preferable that the difference is at least 0.15 eV, and more preferably, at least 0.19 eV

The band profile as shown in FIG. 2A can be provided, for example, by changing the composition of the p-type semiconductor layer 13 in the direction of its own thickness.

More specifically, for example, when the p-type semiconductor layer 13 contains as a group IIIb element at least one element selected from the group consisting of In, Ga and Al, a content of at least one of the above-mentioned elements in the p-type semiconductor layer 13 can be changed in the direction of thickness of the p-type semiconductor layer 13.

Namely, it is possible that in the solar cell 1 of the present invention the p-type semiconductor layer 13 contains Ga as the group IIIb element, the atom number ratio of Ga to the group IIIb elements in the p-type semiconductor layer 13, that is, the value of (Ga atom number) / (atom number of group IIIb elements) (hereinafter, it may be referred to as an atom number ratio $X_1$) increases from the n-type semiconductor layer 14 side to the first electrode layer 12 side monotonically. For example, when the p-type semiconductor layer 13 includes $Cu(In,Ga)Se_2$, the atom number ratio $X_1$ is (Ga atom number) / (Ga atom number + In atom number). At this time, it will be required in the p-type semiconductor layer 13 that an increase rate of the atom number ratio $X_1$ in the first region 21 at the n-type semiconductor layer 14 side and an increase rate of the atom number ratio $X_1$ in the second region 22 at the first electrode layer 12 side are different from each other. In this manner, by changing the atom number ratio $X_1$ of Ga to the group IIIb elements, the band profile for the p-type semiconductor layer 13 as shown in FIG. 2A can be provided. That is, by providing a solar cell 1 configured in this manner, the solar cell includes as a light-absorption layer of a compound semiconductor with a chalcopyrite structure, and the characteristics such as the conversion efficiency are excellent.

It will be required that the increase rate of the atom number ratio $X_1$ in the first region 21 and the increase rate of the atom number ratio $X_1$ in the second region 22 are different from each other. It is particularly preferred that the increase rate of the atom number ratio $X_1$ in the second region 22 is smaller than the increase rate of the atom number ratio $X_1$ in the first region 21. Thereby, it is possible to obtain a solar cell where a bandgap increase rate in the second region 22 is smaller than the bandgap increase rate in the first region 21. Such a solar cell can have excellent characteristics such as conversion efficiency.

In the solar cell 1 of the present invention, alternatively the p-type semiconductor layer 13 includes Al as the group IIIb element, and the atom number ratio of Al to the group IIIb elements in the p-type semiconductor layer 13, that is, the value of (Al atom number) / (atom number of group IIIb elements) (hereinafter may be referred to as an atom number ratio $X_2$) increases from the n-type semiconductor layer 14 side to the first electrode layer 12 side. At this time, it will be required in the p-type semiconductor layer 13 that an increase rate of the atom number ratio $X_2$ in the first region 21 at the n-type semiconductor layer 14 side and an increase rate of the atom number ratio $X_2$ in the second region 22 at the first electrode layer 12 side are different from each other. In this manner, by changing the atom number ratio $X_2$ of Al to the group IIIb elements, the band profile for the p-type semiconductor layer 13 as shown in FIG. 2A can be provided.

It will be required that the increase rate of the atom number ratio $X_2$ in the first region 21 and the increase rate of the atom number ratio $X_2$ in the second region 22 are different from each other. It is particularly preferred that the increase rate of the atom number ratio $X_2$ in the second region 22 is smaller than the increase rate of the atom number ratio $X_2$ in the first region 21. In this manner, a solar cell where a bandgap increase rate in the second region 22 is smaller than the bandgap increase rate in the first region 21 can be obtained. Such a solar cell can have further excellent characteristics such as conversion efficiency.

The bandgap in the thickness direction of the p-type semiconductor layer 13 can be controlled also when, for example, the p-type semiconductor layer 13 includes Ag and Cu as group Ib elements, the atom number of Ag to the atom number of the group Ib elements is changed in a direction of thickness of the p-type semiconductor layer 13; or, for example, when the p-type semiconductor layer 13 contains Se and S as the group VIb elements, and the atom number ratio of S to the atom number of the group VIb elements is changed in a direction of thickness of the p-type semiconductor layer 13. The above-mentioned controls of the atom number ratios can be combined arbitrarily.

When the p-type semiconductor layer 13 contains Ga as the group IIIb element, the atom number ratio $X_1$ on the main surface at the n-type semiconductor layer 14 side is at least 0.1 for example, and the atom number ratio $X_1$ on the main surface at the first electrode layer 12 side is at least 0.25 for example. In the thus obtained solar cell, the bandgap on the main surface at the n-type semiconductor layer 14 side is at least 1.08 eV, and the bandgap on the main surface at the first electrode layer 12 side is at least 1.17 eV

In a solar cell like the solar cell 1 shown in FIG. 1 where the first electrode layer 12, the p-type semiconductor layer 13 and the n-type semiconductor layer 14 are arranged adjacent to each other, a part of the p-type semiconductor layer 13 adjacent to the n-type semiconductor layer 14 has an atom number ratio $X_1$ of at least 0.1, and a part of the p-type semiconductor layer 13 adjacent to the first electrode layer 12 has an atom number ratio $X_1$ of at least 0.25.

In the solar cell 1 of the present invention, there is no particular upper limit for the respective atom number ratios $X_1$. The upper limit for the atom number ratio $X_1$ of the p-type semiconductor layer 13 on the main surface at the n-type semiconductor layer 14 side is 0.6 (preferably 0.4) for example, and the upper limit for the atom number ratio $X_1$ of the p-type semiconductor layer 13 on the main surface at the first electrode layer 12 side is 0.9 (preferably 0.8) for example.

In the solar cell 1 of the present invention, the atom number ratio $X_1$ of the p-type semiconductor layer 13 at the n-type semiconductor layer 14 side can be 0.3 or more. Furthermore, in the solar cell 1 of the present invention, the atom number ratio $X_1$ of the p-type semiconductor layer 13 at the first electrode layer 12 side can be 0.45 or more. It is particularly preferable that the atom number ratio $X_1$ of the p-type semiconductor layer 13 at the n-type semiconductor layer 14 side is at least 0.3 and the atom number ratio $X_1$ of the p-type semiconductor layer 13 at the first electrode layer 12 side is at least 0.45, since the characteristics such as the conversion efficiency of the solar cell can be further excellent.

When the p-type semiconductor layer 13 contains Ga as a group IIIb element, a difference between the atom number ratio $X_1$ on the main surface at the n-type semiconductor layer 14 side and the atom number ratio $X_1$ on the main surface at the first electrode layer 12 side is at least 0.1 for example. Preferably, the difference is at least 0.15, and more preferably, at least 0.3.

The remaining layers in a solar cell of the present invention will be described below.

The material used for the substrate 11 is not limited particularly, and any materials used typically for solar cells can be used. The examples include a substrate made of non-metal materials such as glass and polyimide, and furthermore, substrates of aluminum alloy such as duralumin and metals such as stainless steel. When the solar cell of the present invention is an integrated solar cell prepared by forming on a substrate 11 a plurality of unit cells connected in series, at least the surface of the substrate 11 must be insulating. For this reason, when a conductive substrate (for example, a stainless steel substrate) is used, an insulating layer must be formed on the surface of the substrate, or the substrate surface must be insulated.

A material used for the first electrode layer 12 is not limited particularly as long as it is electrically conductive. For example, the material can be a metal or a semiconductor or the like whose volume resistivity is not more than $6 \times 10^6 \, \Omega \cdot$ cm. Specifically, Mo (molybdenum) can be used. The shape of the first electrode layer 12 is not limited particularly, but it can be defined arbitrarily in accordance with a shape required for the solar cell 1. The shapes of the remaining layers can be determined similarly. The thickness of the first electrode layer is in a range of about 0.1 $\mu$m to about 1 $\mu$m, for example.

A material used for the n-type semiconductor layer 14 is not limited particularly as long as it can form a p-n junction with the p-type semiconductor layer 13. CdS or a compound containing Zn can be used, for example. The Zn-containing compound is, for example, Zn(O,S) and ZnMgO. The n-type semiconductor layer 15 can be made of a material different from that of the n-type semiconductor layer 14. For example, ZnO or a material containing ZnO can be used. The thicknesses of the n-type semiconductor layer 14 and the n-type semiconductor layer 15 are in a range of 5 nm to 200 nm, and in a range of 50 nm to 200 nm respectively for example. As mentioned above, the n-type semiconductor layer 15 can be omitted.

The second electrode layer 16 at the light-incidence side can be formed of, for example, a conductive material having translucency. Here, "translucency" can be relative to light in a band for entering the solar cell 1. Specific examples thereof include indium tin oxide (ITO), ZnO, ZnO doped with a group IIIb element such as Al, or a laminate film of these materials. The second electrode layer 16 has a thickness of, for example, in a range of about 0.1 $\mu$m to about 0.6 $\mu$m.

Materials used for the extraction electrodes 17 and 18 are not limited particularly as long as the materials can be used typically for solar cells. The examples include NiCr, Ag, Au, and Al.

In the solar cell 1 as shown in FIG. 1, the first electrode layer 12, the p-type semiconductor layer 13, the n-type semiconductor layer 14, the n-type semiconductor layer 15 and the second electrode layer 16 are arranged on the substrate 11. The substrate 11 is not an essential component in the solar cell of the present invention, and it can be omitted as required. Similarly, the extraction electrodes 17 and 18 can be omitted as required. In the solar cell 1 of the present invention, arbitrary layers can be interposed between the respective layers as required.

Layers other than the p-type semiconductor layer 13 in the solar cell of the present invention can be produced by an arbitrary method for manufacturing a solar cell. For forming the first electrode layer 12 on the substrate 11, for example, a sputtering method or a vapor deposition method can be used. For forming the n-type semiconductor layers 14 and 15 on the p-type semiconductor layer 13, for example, a sputtering method can be used. For forming the second electrode layer 16, for example, a sputtering method can be used. A method for forming the extraction electrodes 17 and 18 is not limited particularly as long as the respective extraction electrodes can be connected electrically to the respective electrode layers, and any ordinary methods can be used.

A vapor deposition method for example, or more preferably, a multisource vapor deposition method or the like can be used for forming the p-type semiconductor layer 13 on the first electrode layer 12. A multisource vapor deposition denotes a vapor deposition using a plurality of vapor deposition sources. For example, for forming a p-type semiconductor layer 13 containing $Cu(In,Ga)Se_2$, four kinds of vapor deposition sources including a Cu vapor deposition source, an In vapor deposition source, a Ga vapor deposition source and a Se vapor deposition source are used. At this time, for example, energy to be applied to the Ga vapor deposition source is controlled and a speed of thermal diffusion of Ga atoms with respect to the other atoms is controlled so as to form a p-type semiconductor layer 13 where the atom number ratio $X_1$ of Ga changes in the direction of its own thickness. Alternatively for example, a Ga layer is formed previously on the first electrode layer 12 by sputtering, vapor deposition or the like, and further a $Cu(In,Ga) Se_2$ layer is formed on the thus formed Ga layer, which is then heated to diffuse the Ga atoms so as to form a p-type semiconductor layer 13 where the Ga atom number ratio $X_1$ changes in the direction of its own thickness. A similar method can be used for forming a p-type semiconductor layer 13 where an atom number ratio of either Al or In changes in a direction of its own thickness (i.e., Ga in the above-mentioned method is replaced by Al or In). The method for forming the p-type semiconductor layer 13 is not limited to the above-mentioned examples, but any methods can be used without any particular limitations as long as the p-type semiconductor layer 13 of the above-mentioned configuration can be provided.

(Embodiment)

The following explanation is about the results for effectiveness of a solar cell of the present invention, and the results were obtained through a simulation.

In the embodiment, the characteristics simulation was conducted by changing the band profile of the p-type semiconductor layer 13 as a light-absorption layer.

First, a model of a solar cell used in the simulation will be described. For the model of the solar cell, the solar cell as shown in FIG. 1 was used. Specifically, the simulation was carried out under the condition as shown in Table 1.

(Table 1)

|  | Materials | Thickness ($\mu$m) | Carrier concentration ($/m^3$) |
|---|---|---|---|
| Second electrode layer 16 | ITO | 0.1 | $1.0 \times 10^{26}$ |
| n-type semiconductor layer 15 | ZnO | 0.1 | $1.0 \times 10^{20}$ |
| n-type semiconductor layer 14 | CdS | 0.1 | $1.0 \times 10^{21}$ |
| p-type semiconductor layer 13 | $Cu(In,Ga)Se_2$ | 2.0 | $1.0 \times 10^{22}$ |
| First electrode layer 12 | Mo | 1.0 | - |

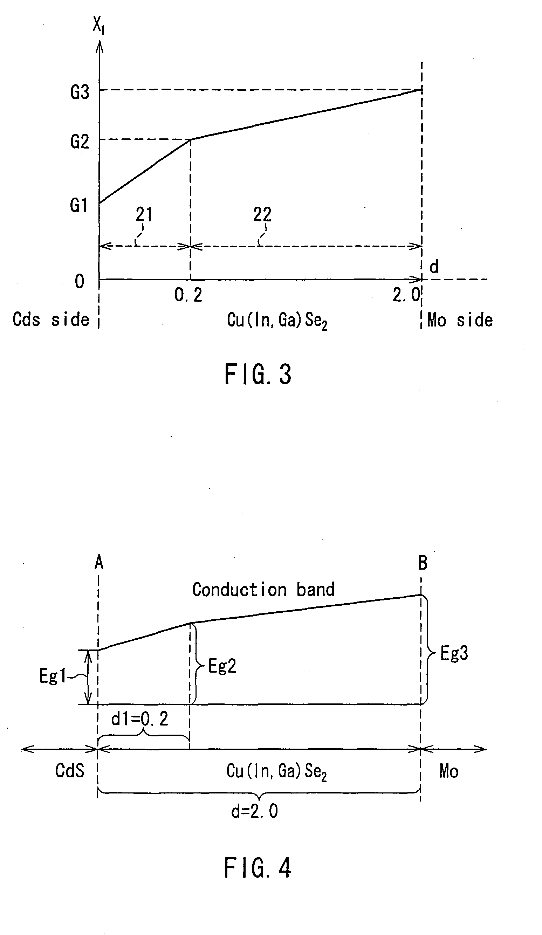

The band profile of the p-type semiconductor layer 13 was controlled by changing the atom number ratio $X_1$ of Ga in the $Cu(In,Ga)Se_2$ of the p-type semiconductor layer 13 ($X_1$ = (Ga atom number) / (Ga atom number + In atom number)). Specifically, in a $Cu(In,Ga)Se_2$ layer (p-type semiconductor layer), the atom number ratio $X_1$ on the main surface at the CdS layer (n-type semiconductor layer) side is determined to be G1, and the atom number ratio $X_1$ on the main surface at the Mo layer (first electrode layer) side is determined to be G3. G2 denotes an atom number ratio $X_1$ at a point in the $Cu(In,Ga)Se_2$ layer 0.2 $\mu$m inside from the main surface at the CdS layer side. The atom number ratio $X_1$ was changed between G1 and G2, and between G2 and G3 in a straight line. That is, the Ga atom number ratio $X_1$ in the first region 21 and the Ga atom number ratio $X_1$ in the second region 22 are values changing in a straight line. When G3 > G2 > G1, the atom number ratios $X_1$ in both the first and second regions increase from the CdS side to the Mo side monotonically. At this time, the values of G3, G2 and G1 can be defined suitably to match or differentiate an increase rate of the atom number ratio $X_1$ in the first region and an increase rate of the atom number ratio $X_1$ in the

second region. When G1 > G2, G3 > G2 and G3 > G1, a solar cell including a Cu(In,Ga)Se$_2$ layer with a double graded structure as mentioned above can be provided. In FIG. 3, the x-axis indicates a thickness direction of the Cu(In,Ga)Se$_2$ layer, and 0 and 2.0 indicates a CdS layer side and a Mo layer side respectively. The y-axis in FIG. 3 denotes an atom number ratio X$_1$.

Between the atom number ratio X$_1$ and the bandgap Eg, in general, a relationship expressed by the following formula is established.

$$Eg = 0.11 \cdot X_1{}^2 + 0.56 \cdot X_1 + 1.02 \qquad (1)$$

Therefore, it is considered that, by controlling the atom number ratio X$_1$ in a direction of thickness of the Cu(In,Ga)Se$_2$ layer as shown in FIG. 3, a bandgap as shown in FIG. 4 can be obtained. A bandgap at an atom number ratio X$_1$ = G1 is Eg1, a bandgap at an atom number ratio X$_1$ = G2 is Eg2, and a bandgap at an atom number ratio X$_1$ = G3 is Eg3.

(Example 1)

In Example 1, a simulation of characteristics of solar cells was conducted by changing the values of G1, G2 and G3 as shown in Tables 2-5 below. As shown in Tables 2-5, in Example 1, a difference between G1and G3 was kept to 0.15, and G2 was changed to evaluate the thus obtained characteristics. Specifically, Table 2 indicates a case of G1 = 0.1 (G3 = 0.25), Table 3 indicates a case of G1= 0.2 (G3 = 0.35), Table 4 indicates a case of G1 = 0.3 (G3 = 0.45), and Table 5 indicates a case of G1 = 0.4 (G3 = 0.55). Tables 2-5 also indicate values of bandgaps Eg1-Eg3. The bandgaps Eg1 to Eg3 are values obtained from the above formula (1).

(Table 2)

| Sample No. | Atom number ratio X$_1$ | | | Bandgap Eg | | |
|---|---|---|---|---|---|---|
| | G1 | G2 | G3 | Eg1 | Eg2 | Eg3 |
| 1-1 | 0.1 | 0.00 | 0.25 | 1.08 | 1.02 | 1.17 |
| 1-2 | 0.1 | 0.05 | 0.25 | 1.08 | 1.05 | 1.17 |
| 1-3 | 0.1 | 0.1 | 0.25 | 1.08 | 1.08 | 1.17 |
| 1-4 | 0.1 | 0.15 | 0.25 | 1.08 | 1.11 | 1.17 |
| 1-5 | 0.1 | 0.2 | 0.25 | 1.08 | 1.14 | 1.17 |
| 1-6 | 0.1 | 0.25 | 0.25 | 1.08 | 1.17 | 1.17 |
| 1-7 | 0.1 | 0.3 | 0.25 | 1.08 | 1.20 | 1.17 |
| 1-8 | 0.1 | 0.35 | 0.25 | 1.08 | 1.23 | 1.17 |
| 1-9 | 0.1 | 0.4 | 0.25 | 1.08 | 1.26 | 1.17 |
| 1-10 | 0.1 | 0.45 | 0.25 | 1.08 | 1.29 | 1.17 |
| 1-11 | 0.1 | 0.5 | 0.25 | 1.08 | 1.33 | 1.17 |
| 1-12 | 0.1 | 0.55 | 0.25 | 1.08 | 1.36 | 1.17 |
| 1-13 | 0.1 | 0.6 | 0.25 | 1.08 | 1.40 | 1.17 |
| 1-14 | 0.1 | 0.65 | 0.25 | 1.08 | 1.43 | 1.17 |
| 1-15 | 0.1 | 0.7 | 0.25 | 1.08 | 1.47 | 1.17 |
| 1-16 | 0.1 | 0.75 | 0.25 | 1.08 | 1.50 | 1.17 |
| 1-17 | 0.1 | 0.8 | 0.25 | 1.08 | 1.54 | 1.17 |
| 1-18 | 0.1 | 0.85 | 0.25 | 1.08 | 1.58 | 1.17 |
| 1-19 | 0.1 | 0.9 | 0.25 | 1.08 | 1.61 | 1.17 |
| 1-20 | 0.1 | 0.95 | 0.25 | 1.08 | 1.65 | 1.17 |

Table continued

| Sample No. | Atom number ratio $X_1$ | | | Bandgap Eg | | |
|---|---|---|---|---|---|---|
| | G1 | G2 | G3 | Eg1 | Eg2 | Eg3 |
| 1-21 | 0.1 | 1.0 | 0.25 | 1.08 | 1.69 | 1.17 |

Here, samples 1-1 to 1-3 denote solar cells, each including a Cu(In,Ga)Se$_2$ layer with the above-mentioned double graded structure. Samples 1-4 to 1-6 denote solar cells where the bandgap of the Cu(In,Ga)Se$_2$ layer increases from the CdS layer side to the Mo layer side monotonically, and the first region and the second region are different from each other in the bandgap increase rate in a thickness direction of the Cu(In,Ga)Se$_2$ layer. In each of samples 1-4 to 1-6, the bandgap increase rate in the first region is larger than the bandgap increase rate in the second region. Sample 1-7 and the following samples are not included in the above-mentioned solar cells of the present invention, since G2 > G3.

(Table 3)

| Sample No. | Atom number ratio $X_1$ | | | Bandgap Eg | | |
|---|---|---|---|---|---|---|
| | G1 | G2 | G3 | Eg1 | Eg2 | Eg3 |
| 2-1 | 0.2 | 0.0 | 0.35 | 1.14 | 1.02 | 1.23 |
| 2-2 | 0.2 | 0.05 | 0.35 | 1.14 | 1.05 | 1.23 |
| 2-3 | 0.2 | 0.10 | 0.35 | 1.14 | 1.08 | 1.23 |
| 2-4 | 0.2 | 0.15 | 0.35 | 1.14 | 1.11 | 1.23 |
| 2-5 | 0.2 | 0.2 | 0.35 | 1.14 | 1.14 | 1.23 |
| 2-6 | 0.2 | 0.25 | 0.35 | 1.14 | 1.17 | 1.23 |
| 2-7 | 0.2 | 0.3 | 0.35 | 1.14 | 1.20 | 1.23 |
| 2-8 | 0.2 | 0.35 | 0.35 | 1.14 | 1.23 | 1.23 |
| 2-9 | 0.2 | 0.4 | 0.35 | 1.14 | 1.26 | 1.23 |
| 2-10 | 0.2 | 0.45 | 0.35 | 1.14 | 1.29 | 1.23 |
| 2-11 | 0.2 | 0.5 | 0.35 | 1.14 | 1.33 | 1.23 |
| 2-12 | 0.2 | 0.55 | 0.35 | 1.14 | 1.36 | 1.23 |
| 2-13 | 0.2 | 0.6 | 0.35 | 1.14 | 1.40 | 1.23 |
| 2-14 | 0.2 | 0.65 | 0.35 | 1.14 | 1.43 | 1.23 |
| 2-15 | 0.2 | 0.7 | 0.35 | 1.14 | 1.47 | 1.23 |
| 2-16 | 0.2 | 0.75 | 0.35 | 1.14 | 1.50 | 1.23 |
| 2-17 | 0.2 | 0.8 | 0.35 | 1.14 | 1.54 | 1.23 |
| 2-18 | 0.2 | 0.85 | 0.35 | 1.14 | 1.58 | 1.23 |
| 2-19 | 0.2 | 0.9 | 0.35 | 1.14 | 1.61 | 1.23 |
| 2-20 | 0.2 | 0.95 | 0.35 | 1.14 | 1.65 | 1.23 |
| 2-21 | 0.2 | 1.0 | 0.35 | 1.14 | 1.69 | 1.23 |

Here, samples 2-1 to 2-5 denote solar cells, each including a Cu(In,Ga)Se$_2$, layer with the above-mentioned double graded structure. Samples 2-6 to 2-8 denote solar cells where the bandgap of the Cu(In,Ga)Se$_2$ layer increases from the CdS layer side to the Mo layer side monotonically, and the first region and the second region are different from each other in the bandgap increase rate in a thickness direction of the Cu(In,Ga)Se$_2$ layer. In each of samples 2-6 to 2-8, the bandgap increase rate in the first region is larger than the bandgap increase rate in the second region. Sample 2-9 and the following samples are not included in the above-mentioned solar cells of the present invention, since G2 > G3.

(Table 4)

| Sample No. | Atom number ratio $X_1$ | | | Bandgap Eg | | |
|---|---|---|---|---|---|---|
|  | G1 | G2 | G3 | Eg1 | Eg2 | Eg3 |
| 3-1 | 0.3 | 0.0 | 0.45 | 1.2 | 1.02 | 1.29 |
| 3-2 | 0.3 | 0.05 | 0.45 | 1.2 | 1.05 | 1.29 |
| 3-3 | 0.3 | 0.1 | 0.45 | 1.2 | 1.08 | 1.29 |
| 3-4 | 0.3 | 0.15 | 0.45 | 1.2 | 1.11 | 1.29 |
| 3-5 | 0.3 | 0.2 | 0.45 | 1.2 | 1.14 | 1.29 |
| 3-6 | 0.3 | 0.25 | 0.45 | 1.2 | 1.17 | 1.29 |
| 3-7 | 0.3 | 0.3 | 0.45 | 1.2 | 1.20 | 1.29 |
| 3-8 | 0.3 | 0.35 | 0.45 | 1.2 | 1.23 | 1.29 |
| 3-9 | 0.3 | 0.4 | 0.45 | 1.2 | 1.26 | 1.29 |
| 3-10 | 0.3 | 0.45 | 0.45 | 1.2 | 1.29 | 1.29 |
| 3-11 | 0.3 | 0.5 | 0.45 | 1.2 | 1.33 | 1.29 |
| 3-12 | 0.3 | 0.55 | 0.45 | 1.2 | 1.36 | 1.29 |
| 3-13 | 0.3 | 0.6 | 0.45 | 1.2 | 1.40 | 1.29 |
| 3-14 | 0.3 | 0.65 | 0.45 | 1.2 | 1.43 | 1.29 |
| 3-15 | 0.3 | 0.7 | 0.45 | 1.2 | 1.47 | 1.29 |
| 3-16 | 0.3 | 0.75 | 0.45 | 1.2 | 1.50 | 1.29 |
| 3-17 | 0.3 | 0.8 | 0.45 | 1.2 | 1.54 | 1.29 |
| 3-18 | 0.3 | 0.85 | 0.45 | 1.2 | 1.58 | 1.29 |
| 3-19 | 0.3 | 0.9 | 0.45 | 1.2 | 1.61 | 1.29 |
| 3-20 | 0.3 | 0.95 | 0.45 | 1.2 | 1.65 | 1.29 |
| 3-21 | 0.3 | 1.0 | 0.45 | 1.2 | 1.69 | 1.29 |

Here, samples 3-1 to 3-7 denote solar cells, each including a $Cu(In,Ga)Se_2$ layer with the above-mentioned double graded structure. Samples 3-8 to 3-10 denote solar cells where the bandgap of the $Cu(In,Ga)Se_2$ layer increases from the CdS layer side to the Mo layer side monotonically, and the first region and the second region are different from each other in the bandgap increase rate in a thickness direction of the $Cu(In,Ga)Se_2$ layer. In each of samples 3·8 to 3·10, the bandgap increase rate in the first region is larger than the bandgap increase rate in the second region. Sample 3-11 and the following samples are not included in the above-mentioned solar cells of the present invention, since G2 > G3.

(Table 5)

| Sample No. | Atom number ratio $X_1$ | | | Bandgap Eg | | |
|---|---|---|---|---|---|---|
|  | G1 | G2 | G3 | Eg1 | Eg2 | Eg3 |
| 4-1 | 0.4 | 0.0 | 0.55 | 1.26 | 1.02 | 1.36 |
| 4-2 | 0.4 | 0.05 | 0.55 | 1.26 | 1.05 | 1.36 |
| 4-3 | 0.4 | 0.1 | 0.55 | 1.26 | 1.08 | 1.36 |
| 4-4 | 0.4 | 0.15 | 0.55 | 1.26 | 1.11 | 1.36 |
| 4-5 | 0.4 | 0.2 | 0.55 | 1.26 | 1.14 | 1.36 |
| 4-6 | 0.4 | 0.25 | 0.55 | 1.26 | 1.17 | 1.36 |
| 4-7 | 0.4 | 0.3 | 0.55 | 1.26 | 1.20 | 1.36 |

Table continued

| | Atom number ratio $X_1$ | | | Bandgap Eg | | |
|---|---|---|---|---|---|---|
| Sample No. | G1 | G2 | G3 | Eg1 | Eg2 | Eg3 |
| 4-8 | 0.4 | 0.35 | 0.55 | 1.26 | 1.23 | 1.36 |
| 4-9 | 0.4 | 0.4 | 0.55 | 1.26 | 1.26 | 1.36 |
| 4-10 | 0.4 | 0.45 | 0.55 | 1.26 | 1.29 | 1.36 |
| 4-11 | 0.4 | 0.5 | 0.55 | 1.26 | 1.33 | 1.36 |
| 4-12 | 0.4 | 0.55 | 0.55 | 1.26 | 1.36 | 1.36 |
| 4-13 | 0.4 | 0.6 | 0.55 | 1.26 | 1.40 | 1.36 |
| 4-14 | 0.4 | 0.65 | 0.55 | 1.26 | 1.43 | 1.36 |
| 4-15 | 0.4 | 0.7 | 0.55 | 1.26 | 1.47 | 1.36 |
| 4-16 | 0.4 | 0.75 | 0.55 | 1.26 | 1.50 | 1.36 |
| 4-17 | 0.4 | 0.8 | 0.55 | 1.26 | 1.54 | 1.36 |
| 4-18 | 0.4 | 0.85 | 0.55 | 1.26 | 1.58 | 1.36 |
| 4-19 | 0.4 | 0.9 | 0.55 | 1.26 | 1.61 | 1.36 |
| 4-20 | 0.4 | 0.95 | 0.55 | 1.26 | 1.65 | 1.36 |
| 4-21 | 0.4 | 1.0 | 0.55 | 1.26 | 1.69 | 1.36 |

Here, samples 4-1 to 4-9 denote solar cells, each including a Cu(In,Ga)Se$_2$ layer with the above-mentioned double graded structure. Samples 4-10 to 4-12 denote solar cells where the bandgap of the Cu(In,Ga)Se2 layer increases from the CdS layer side to the Mo layer side monotonically, and the first region and the second region are different from each other in the bandgap increase rate in a thickness direction of the Cu(In,Ga)Se$_2$ layer. In each of samples 4-10 to 4-12, the bandgap increase rate in the first region is larger than the bandgap increase rate in the second region. Sample 4-13 and the following samples are not included in the above-mentioned solar cells of the present invention, since G2 > G3.

Simulation was conducted for the respective samples indicated in Tables 2-5 so as to calculate values for a short-circuit current density Jsc (mA/cm$^2$), an open-end voltage Voc (V), a fill factor (FF) and conversion efficiency (%). In the simulation, an electric current equation of continuity and a Poisson equation derived from a Maxwell's equation were digitized in a steady state by using a finite difference method, and a numerical calculation was conducted. The results are shown in Tables 6-9.

(Table 6)

| Sample No. | Jsc (mA/cm$^2$) | Voc (V) | FF | Conversion Efficiency (%) |
|---|---|---|---|---|
| 1-1 | 40.5 | 0.609 | 0.600 | 14.8 |
| 1-2 | 39.8 | 0.624 | 0.638 | 15.9 |
| 1-3 | 39.1 | 0.639 | 0.672 | 16.8 |
| 1-4 | 38.3 | 0.655 | 0.700 | 17.5 |
| 1-5 | 37.2 | 0.669 | 0.723 | 18.0 |
| 1-6 | 35.6 | 0.682 | 0.741 | 18.0 |
| 1-7 | 33.7 | 0.694 | 0.754 | 17.7 |
| 1-8 | 31.3 | 0.704 | 0.764 | 16.8 |
| 1-9 | 28.5 | 0.712 | 0.770 | 15.6 |
| 1-10 | 25.8 | 0.719 | 0.776 | 14.4 |
| 1-11 | 23.5 | 0.724 | 0.780 | 13.3 |
| 1-12 | 21.8 | 0.728 | 0.783 | 12.4 |

Table continued

| Sample No. | Jsc (mA/cm$^2$) | Voc (V) | FF | Conversion Efficiency (%) |
|---|---|---|---|---|
| 1-13 | 20.5 | 0.730 | 0.786 | 11.7 |
| 1-14 | 19.4 | 0.733 | 0.789 | 11.2 |
| 1-15 | 18.5 | 0.735 | 0.792 | 10.8 |
| 1-16 | 17.7 | 0.737 | 0.794 | 10.4 |
| 1-17 | 17.1 | 0.738 | 0.795 | 10.0 |
| 1-18 | 16.5 | 0.740 | 0.797 | 9.7 |
| 1-19 | 15.9 | 0.742 | 0.799 | 9.5 |
| 1-20 | 15.5 | 0.743 | 0.801 | 9.2 |
| 1-21 | 15.0 | 0.744 | 0.802 | 9.0 |

(Table 7)

| Sample No. | Jsc (mA/cm$^2$) | Voc (V) | FF. | Conversion Efficiency (%) |
|---|---|---|---|---|
| 2-1 | 40.1 | 0.618 | 0.585 | 14.5 |
| 2-2 | 39.6 | 0.634 | 0.633 | 15.9 |
| 2-3 | 39.0 | 0.652 | 0.676 | 17.2 |
| 2-4 | 38.3 | 0.670 | 0.712 | 18.3 |
| 2-5 | 37.5 | 0.687 | 0.742 | 19.1 |
| 2-6 | 36.4 | 0.705 | 0.764 | 19.6 |
| 2-7 | 35.1 | 0.721 | 0.781 | 19.7 |
| 2-8 | 33.4 | 0.735 | 0.792 | 19.5 |
| 2-9 | 31.3 | 0.748 | 0.799 | 18.7 |
| 2-10 | 29.0 | 0.759 | 0.802 | 17.7 |
| 2-11 | 26.3 | 0.767 | 0.804 | 16.2 |
| 2-12 | 23.7 | 0.774 | 0.806 | 14.8 |
| 2-13 | 21.7 | 0.779 | 0.807 | 13.6 |
| 2-14 | 20.0 | 0.782 | 0.809 | 12.7 |
| 2-15 | 18.8 | 0.785 | 0.810 | 12.0 |
| 2-16 | 17.8 | 0.787 | 0.811 | 11.4 |
| 2-17 | 17.0 | 0.790 | 0.812 | 10.9 |
| 2-18 | 16.4 | 0.792 | 0.813 | 10.5 |
| 2-19 | 15.8 | 0.794 | 0.814 | 10.2 |
| 2-20 | 15.2 | 0.796 | 0.815 | 9.9 |
| 2-21 | 14.7 | 0.797 | 0.815 | 9.6 |

(Table 8)

| Sample No. | Jsc (mA/cm$^2$) | Voc (V) | FF | Conversion Efficiency (%) |
|---|---|---|---|---|
| 3-1 | 39.3 | 0.627 | 0.486 | 12.0 |

Table continued

| Sample No. | Jsc (mA/cm$^2$) | Voc (V) | FF | Conversion Efficiency (%) |
|---|---|---|---|---|
| 3-2 | 38.9 | 0.643 | 0.551 | 13.8 |
| 3-3 | 38.4 | 0.661 | 0.616 | 15.6 |
| 3-4 | 37.8 | 0.680 | 0.675 | 17.3 |
| 3-5 | 37.1 | 0.700 | 0.722 | 18.8 |
| 3-6 | 36.2 | 0.721 | 0.759 | 19.8 |
| 3-7 | 35.1 | 0.741 | 0.784 | 20.4 |
| 3-8 | 34.0 | 0.760 | 0.802 | 20.7 |
| 3-9 | 33.0 | 0.778 | 0.813 | 20.9 |
| 3-10 | 31.5 | 0.794 | 0.818 | 20.4 |
| 3-11 | 29.5 | 0.807 | 0.821 | 19.5 |
| 3-12 | 27.0 | 0.818 | 0.821 | 18.1 |
| 3-13 | 24.2 | 0.827 | 0.819 | 16.4 |
| 3-14 | 21.7 | 0.833 | 0.818 | 14.8 |
| 3-15 | 19.7 | 0.838 | 0.817 | 13.5 |
| 3-16 | 18.3 | 0.842 | 0.817 | 12.6 |
| 3-17 | 17.3 | 0.845 | 0.817 | 11.9 |
| 3-18 | 16.4 | 0.847 | 0.816 | 11.3 |
| 3-19 | 15.7 | 0.850 | 0.816 | 10.9 |
| 3-20 | 15.0 | 0.852 | 0.816 | 10.5 |
| 3-21 | 14.5 | 0.854 | 0.816 | 10.1 |

(Table 9)

| Sample No. | Jsc (mA/cm$^2$) | Voc (V) | FF | Conversion Efficiency |
|---|---|---|---|---|
| 4-1 | 37.9 | 0.648 | 0.303 | 7.4 |
| 4-2 | 37.7 | 0.659 | 0.359 | 8.9 |
| 4-3 | 37.4 | 0.674 | 0.429 | 10.8 |
| 4-4 | 37.0 | 0.692 | 0.510 | 13.0 |
| 4-5 | 36.4 | 0.711 | 0.600 | 15.5 |
| 4-6 | 35.6 | 0.732 | 0.679 | 17.7 |
| 4-7 | 34.8 | 0.754 | 0.740 | 19.4 |
| 4-8 | 33.9 | 0.777 | 0.780 | 20.6 |
| 4-9 | 33.2 | 0.799 | 0.806 | 21.4 |
| 4-10 | 32.3 | 0.821 | 0.820 | 21.7 |
| 4-11 | 31.1 | 0.840 | 0.827 | 21.6 |
| 4-12 | 29.7 | 0.857 | 0.829 | 21.1 |
| 4-13 | 27.6 | 0.871 | 0.828 | 19.9 |
| 4-14 | 24.9 | 0.883 | 0.823 | 18.1 |
| 4-15 | 22.1 | 0.891 | 0.818 | 16.1 |

Table continued

| Sample No. | Jsc (mA/cm$^2$) | Voc (V) | FF | Conversion Efficiency |
|---|---|---|---|---|
| 4-16 | 19.7 | 0.898 | 0.814 | 14.4 |
| 4-17 | 17.9 | 0.903 | 0.810 | 13.1 |
| 4-18 | 16.7 | 0.907 | 0.808 | 12.2 |
| 4-19 | 15.7 | 0.911 | 0.806 | 11.5 |
| 4-20 | 15.0 | 0.914 | 0.803 | 11.0 |
| 4-21 | 14.3 | 0.917 | 0.801 | 10.5 |

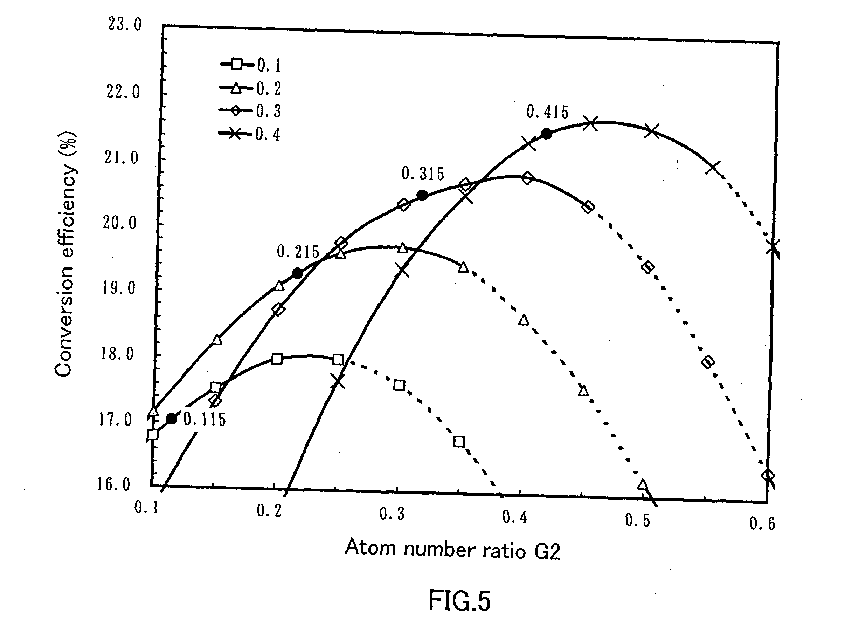

For clarifying the results as shown Tables 6-9, parts of the results in Tables 6-9 are shown in FIG. 5. The introductory notes in FIG. 5 denote values of G1. Namely for example, a line connecting the respective points expressed with a mark □ in FIG. 5 denotes a part of the results for the case of G1 = 0.1 (the results as shown in Table 6). The x-axis in FIG. 5 denotes an atom number ratio G2, and the y-axis denotes conversion efficiency (%). The black dot (●) on each line denotes a G2 value that the atom number ratio $X_1$ increases while keeping a constant increase rate from the CdS layer side to the Mo layer side. That is, the values reflect samples of solar cells, each having either an increase rate of the atom number ratio $X_1$ or a bandgap increase rate being constant in a comparison between a first region and a second region in a Cu(In,Ga)Se$_2$ layer (such a solar cell is called also a solar cell whose light-absorption layer has a single graded structure). As shown in FIG. 5, for example, when G1 = 0.1 and G2 = 0.115, or when G1 = 0.2 and G2 = 0.215, a sample of a solar cell with such a single graded structure will be provided. The broken line part in each line denotes a region of a sample group for solar cells where G2 > G3. That is, in each line, the region positioned at right hand of the black dot (●) up to the beginning of the broken line (for example, in a case of a sample group where G1 = 0.1, a region in a range of 0.115 < G2 ≤0.25) denotes a region to indicate a sample group for solar cells each having the bandgap of the Cu(In,Ga)Se$_2$ layer increasing from the CdS layer side to the Mo layer side and the bandgap increase rate in a direction of thickness of the Cu(In,Ga)Se$_2$ layer of the first region being different from that of the second region. In each of the lines, the region positioned at left hand of the black dot (●) (for example, in a case of a sample group where G1= 0.1, a region of G2 < 0.015) denotes a region indicating a sample group for solar cells including Cu(In,Ga)Se$_2$ layers as light-absorption layers each having a double graded structure.

It is shown in Tables 6-9 and FIG. 5, that a solar cell will have excellent conversion efficiency when the solar cell includes a Cu(In,Ga)Se$_2$ layer whose bandgap increases from the CdS layer side to the Mo layer side monotonically, and when the bandgap increase rates of a first region and second region in a direction of thickness of the Cu(In,Ga)Se$_2$ layer are different from each other, in comparison with a solar cell configured in a different manner (for example, including a Cu(In,Ga)Se$_2$ layer as a light-absorption layer with a single graded structure or a double graded structure). This effect can be obtained when G1 is 0.1 or more (that is, the bandgap Eg1 is 1.08 eV or more) and G3 is 0.25. or more (that is, the bandgap Eg3 is 1.17 eV or more). For a sample group where G1 is 0.3 or more (that is, the bandgap Eg1 is 1.2 eV or more) and G3 is 0.45 or more (that is, the bandgap Eg3 is 1.3 eV or more), the conversion efficiency exceeded 20%, and thus solar cells with more excellent conversion efficiency were obtained.

(Example 2)

In Example 2, as shown in Tables 10-14 below, values of G1, G2 and G3 were changed to conduct a simulation for the characteristics of the solar cells. As shown in Tables 10-14, in Example 2, a difference between G1 and G3 is kept at 0.3 and G2 was changed so as to evaluate attainable characteristics. Specifically, Table 10 shows a case of G1= 0.1 (G3 = 0.4), Table 11 shows a case of G1 = 0.15 (G3 = 0.45), Table 12 shows a case of G1= 0.2 (G3 = 0.5), Table 13 shows a case of G1= 0.25 (G3 = 0.55), and Table 14 shows a case of G1 = 0.3 (G3 = 0.6). Similarly to Example 1, Tables 10-14 shows also the values of the bandgaps Eg1 to Eg3. The bandgaps Eg1 to Eg3 are obtained from the above formula (1).

(Table 10)

| Sample No. | Atom number ratio $X_1$ | | | Bandgap Eg | | |
|---|---|---|---|---|---|---|
| | G1 | G2 | G3 | Eg1 | Eg2 | Eg3 |
| 5-1 | 0.1 | 0.0 | 0.4 | 1.08 | 1.02 | 1.26 |
| 5-2 | 0.1 | 0.05 | 0.4 | 1.08 | 1.05 | 1.26 |

Table continued

| Sample No. | Atom number ratio $X_1$ | | | Bandgap Eg | | |
|---|---|---|---|---|---|---|
| | G1 | G2 | G3 | Eg1 | Eg2 | Eg3 |
| 5-3 | 0.1 | 0.1 | 0.4 | 1.08 | 1.08 | 1.26 |
| 5-4 | 0.1 | 0.15 | 0.4 | 1.08 | 1.11 | 1.26 |
| 5-5 | 0.1 | 0.2 | 0.4 | 1.08 | 1.14 | 1.26 |
| 5-6 | 0.1 | 0.25 | 0.4 | 1.08 | 1.17 | 1.26 |
| 5-7 | 0.1 | 0.3 | 0.4 | 1.08 | 1.2 | 1.26 |
| 5-8 | 0.1 | 0.35 | 0.4 | 1.08 | 1.23 | 1.26 |
| 5-9 | 0.1 | 0.4 | 0.4 | 1.08 | 1.26 | 1.26 |
| 5-10 | 0.1 | 0.45 | 0.4 | 1.08 | 1.29 | 1.26 |
| 5-11 | 0.1 | 0.5 | 0.4 | 1.08 | 1.33 | 1.26 |
| 5-12 | 0.1 | 0.55 | 0.4 | 1.08 | 1.36 | 1.26 |
| 5-13 | 0.1 | 0.6 | 0.4 | 1.08 | 1.40 | 1.26 |
| 5-14 | 0.1 | 0.65 | 0.4 | 1.08 | 1.43 | 1.26 |
| 5-15 | 0.1 | 0.7 | 0.4 | 1.08 | 1.47 | 1.26 |
| 5-16 | 0.1 | 0.75 | 0.4 | 1.08 | 1.50 | 1.26 |
| 5-17 | 0.1 | 0.8 | 0.4 | 1.08 | 1.54 | 1.26 |
| 5-18 | 0.1 | 0.85 | 0.4 | 1.08 | 1.58 | 1.26 |
| 5-19 | 0.1 | 0.9 | 0.4 | 1.08 | 1.61 | 1.26 |
| 5-20 | 0.1 | 0.95 | 0.4 | 1.08 | 1.65 | 1.26 |
| 5-21 | 0.1 | 1.0 | 0.4 | 1.08 | 1.69 | 1.26 |

Here, samples 5-1 to 5-3 denote solar cells, each including a Cu(In,Ga)Se$_2$ layer with the above-mentioned double graded structure. Samples 5-4 to 5-9 denote solar cells where the bandgap of the Cu(In,Ga)Se$_2$ layer increases from the CdS layer side to the Mo layer side monotonically, and the first region and the second region are different from each other in the bandgap increase rate in a thickness direction of the Cu(In,Ga)Se$_2$ layer. In each of samples 5-4 to 5-9, the bandgap increase rate in the first region is larger than the bandgap increase rate in the second region. Sample 5-10 and the following samples are not included in the above-mentioned solar cells of the present invention, since G2 > G3.

(Table 11)

| Sample No. | Atom number ratio $X_1$ | | | Bandgap Eg | | |
|---|---|---|---|---|---|---|
| | G1 | G2 | G3 | Eg1 | Eg2 | Eg3 |
| 6-1 | 0.15 | 0.0 | 0.45 | 1.11 | 1.02 | 1.29 |
| 6-2 | 0.15 | 0.05 | 0.45 | 1.11 | 1.05 | 1.29 |
| 6-3 | 0.15 | 0.1 | 0.45 | 1.11 | 1.08 | 1.29 |
| 6-4 | 0.15 | 0.15 | 0.45 | 1.11 | 1.11 | 1.29 |
| 6-5 | 0.15 | 0.2 | 0.45 | 1.11 | 1.14 | 1.29 |
| 6-6 | 0.15 | 0.25 | 0.45 | 1.11 | 1.17 | 1.29 |
| 6-7 | 0.15 | 0.3 | 0.45 | 1.11 | 1.20 | 1.29 |
| 6-8 | 0.15 | 0.35 | 0.45 | 1.11 | 1.23 | 1.29 |
| 6-9 | 0.15 | 0.4 | 0.45 | 1.11 | 1.26 | 1.29 |

Table continued

|  | Atom number ratio $X_1$ | | | Bandgap Eg | | |
|:---:|:---:|:---:|:---:|:---:|:---:|:---:|
| Sample No. | G1 | G2 | G3 | Eg1 | Eg2 | Eg3 |
| 6-10 | 0.15 | 0.45 | 0.45 | 1.11 | 1.29 | 1.29 |
| 6-11 | 0.15 | 0.5 | 0.45 | 1.11 | 1.33 | 1.29 |
| 6-12 | 0.15 | 0.55 | 0.45 | 1.11 | 1.36 | 1.29 |
| 6-13 | 0.15 | 0.6 | 0.45 | 1.11 | 1.40 | 1.29 |
| 6-14 | 0.15 | 0.65 | 0.45 | 1.11 | 1.43 | 1.29 |
| 6-15 | 0.15 | 0.7 | 0.45 | 1.11 | 1.47 | 1.29 |
| 6-16 | 0.15 | 0.75 | 0.45 | 1.11 | 1.50 | 1.29 |
| 6-17 | 0.15 | 0.8 | 0.45 | 1.11 | 1.54 | 1.29 |
| 6-18 | 0.15 | 0.85 | 0.45 | 1.11 | 1.58 | 1.29 |
| 6-19 | 0.15 | 0.9 | 0.45 | 1.11 | 1.61 | 1.29 |
| 6-20 | 0.15 | 0.95 | 0.45 | 1.11 | 1.65 | 1.29 |
| 6-21 | 0.15 | 1.0 | 0.45 | 1.11 | 1.69 | 1.29 |

Here, samples 6-1 to 6-4 denote solar cells, each including a Cu(In,Ga)Se$_2$ layer with the above-mentioned double graded structure. Samples 6-5 to 6-10 denote solar cells where the bandgap of the Cu(In,Ga)Se$_2$ layer increases from the CdS layer side to the Mo layer side monotonically, and the first region and the second region are different from each other in the bandgap increase rate in a thickness direction of the Cu(In,Ga)Se$_2$ layer. In each of samples 6-5 to 6-10, the bandgap increase rate in the first region is larger than the bandgap increase rate in the second region. Sample 6-11 and the following samples are not included in the above-mentioned solar cells of the present invention, since G2 > G3.

(Table 12)

|  | Atom number ratio $X_1$ | | | Bandgap Eg | | |
|:---:|:---:|:---:|:---:|:---:|:---:|:---:|
| Sample No. | G1 | G2 | G3 | Eg1 | Eg2 | Eg3 |
| 7-1 | 0.2 | 0.0 | 0.5 | 1.14 | 1.02 | 1.33 |
| 7-2 | 0.2 | 0.05 | 0.5 | 1.14 | 1.05 | 1.33 |
| 7-3 | 0.2 | 0.1 | 0.5 | 1.14 | 1.08 | 1.33 |
| 7-4 | 0.2 | 0.15 | 0.5 | 1.14 | 1.11 | 1.33 |
| 7-5 | 0.2 | 0.2 | 0.5 | 1.14 | 1.14 | 1.33 |
| 7-6 | 0.2 | 0.25 | 0.5 | 1.14 | 1.17 | 1.33 |
| 7-7 | 0.2 | 0.3 | 0.5 | 1.14 | 1.20 | 1.33 |
| 7-8 | 0.2 | 0.35 | 0.5 | 1.14 | 1.23 | 1.33 |
| 7-9 | 0.2 | 0.4 | 0.5 | 1.14 | 1.26 | 1.33 |
| 7-10 | 0.2 | 0.45 | 0.5 | 1.14 | 1.29 | 1.33 |
| 7-11 | 0.2 | 0.5 | 0.5 | 1.14 | 1.33 | 1.33 |
| 7-12 | 0.2 | 0.55 | 0.5 | 1.14 | 1.36 | 1.33 |
| 7-13 | 0.2 | 0.6 | 0.5 | 1.14 | 1.40 | 1.33 |
| 7-14 | 0.2 | 0.65 | 0.5 | 1.14 | 1.43 | 1.33 |
| 7-15 | 0.2 | 0.7 | 0.5 | 1.14 | 1.47 | 1.33 |
| 7-16 | 0.2 | 0.75 | 0.5 | 1.14 | 1.50 | 1.33 |

Table continued

| | Atom number ratio $X_1$ | | | Bandgap Eg | | |
|---|---|---|---|---|---|---|
| Sample No. | G1 | G2 | G3 | Eg1 | Eg2 | Eg3 |
| 7-17 | 0.2 | 0.8 | 0.5 | 1.14 | 1.54 | 1.33 |
| 7-18 | 0.2 | 0.85 | 0.5 | 1.14 | 1.58 | 1.33 |
| 7-19 | 0.2 | .0.9 | 0.5 | 1.14 | 1.61 | 1.33 |
| 7-20 | 0.2 | 0.95 | 0.5 | 1.14 | 1.65 | 1.33 |
| 7-21 | 0.2 | 1.0 | 0.5 | 1.14 | 1.69 | 1.33 |

Here, samples 7-1 to 7-5 denote solar cells, each including a Cu(In,Ga)Se$_2$ layer with the above-mentioned double graded structure. Samples 7-6 to 7-11 denote solar cells where the bandgap of the Cu(In,Ga)Se$_2$ layer increases from the CdS layer side to the Mo layer side monotonically, and the first region and the second region are different from each other in the bandgap increase rate in a thickness direction of the Cu(In,Ga)Se$_2$ layer. In each of samples 7-6 to 7-11, the bandgap increase rate in the first region is larger than the bandgap increase rate in the second region. Sample 7-12 and the following samples are not included in the above-mentioned solar cells of the present invention, since G2 > G3.

(Table 13)

| | Atom number ratio $X_1$ | | | Bandgap Eg | | |
|---|---|---|---|---|---|---|
| Sample No. | G1 | G2 | G3 | Eg1 | Eg2 | Eg3 |
| 8-1 | 0.25 | 0.0 | 0.55 | 1.17 | 1.02 | 1.36 |
| 8-2 | 0.25 | 0.05 | 0.55 | 1.17 | 1.05 | 1.36 |
| 8-3 | 0.25 | 0.1 | 0.55 | 1.17 | 1.08 | 1.36 |
| 8-4 | 0.25 | 0.15 | 0.55 | 1.17 | 1.11 | 1.36 |
| 8-5 | 0.25 | 0.2 | 0.55 | 1.17 | 1.14 | 1.36 |
| 8-6 | 0.25 | 0.25 | 0.55 | 1.17 | 1.17 | 1.36 |
| 8-7 | 0.25 | 0.3 | 0.55 | 1.17 | 1.20 | 1.36 |
| 8-8 | 0.25 | 0.35 | 0.55 | 1.17 | 1.23 | 1.36 |
| 8-9 | 0.25 | 0.4 | 0.55 | 1.17 | 1.26 | 1.36 |
| 8-10 | 0.25 | 0.45 | 0.55 | 1.17 | 1.29 | 1.36 |
| 8-11 | 0.25 | 0.5 | 0.55 | 1.17 | 1.33 | 1.36 |
| 8-12 | 0.25 | 0.55 | 0.55 | 1.17 | 1.36 | 1.36 |
| 8-13 | 0.25 | 0.6 | 0.55 | 1.17 | 1.40 | 1.36 |
| 8-14 | 0.25 | 0.65 | 0.55 | 1.17 | 1.43 | 1.36 |
| 8-15 | 0.25 | 0.7 | 0.55 | 1.17 | 1.47 | 1.36 |
| 8-16 | 0.25 | 0.75 | 0.55 | 1.17 | 1.50 | 1.36 |
| 8-17 | 0.25 | 0.8 | 0.55 | 1.17 | 1.54 | 1.36 |
| 8-18 | 0.25 | 0.85 | 0.55 | 1.17 | 1.58 | 1.36 |
| 8-19 | 0.25 | 0.9 | 0.55 | 1.17 | 1.61 | 1.36 |
| 8-20 | 0.25 | 0.95 | 0.55 | 1.17 | 1.65 | 1.36 |
| 8-21 | 0.25 | 1.0 | 0.55 | 1.17 | 1.69 | 1.36 |

Here, samples 8-1 to 8-6 denote solar cells, each including a Cu(In,Ga)Se$_2$ layer with the above-mentioned double graded structure. Samples 8-7 to 8-12 denote solar cells where the bandgap of the Cu(In,Ga)Se$_2$ layer increases

from the CdS layer side to the Mo layer side monotonically, and the first region and the second region are different from each other in the bandgap increase rate in a thickness direction of the Cu(In,Ga)Se$_2$ layer. In each of samples 8-7 to 8-12; the bandgap increase rate in the first region is larger than the bandgap increase rate in the second region. Sample 8-13 and the following samples are not included in the above-mentioned solar cells of the present invention, since G2 > G3.

(Table 14)

| Sample No. | Atom number ratio $X_1$ | | | Bandgap Eg | | |
|---|---|---|---|---|---|---|
| | G1 | G2 | G3 | Eg1 | Eg2 | Eg3 |
| 9-1 | 0.3 | 0.0 | 0.6 | 1.20 | 1.02 | 1.40 |
| 9-2 | 0.3 | 0.05 | 0.6 | 1.20 | 1.05 | 1.40 |
| 9-3 | 0.3 | 0.1 | 0.6 | 1.20 | 1.08 | 1.40 |
| 9-4 | 0.3 | 0.15 | 0.6 | 1.20 | 1.11 | 1.40 |
| 9-5 | 0.3 | 0.2 | 0.6 | 1.20 | 1.14 | 1.40 |
| 9-6 | 0.3 | 0.25 | 0.6 | 1.20 | 1.17 | 1.40 |
| 9-7 | 0.3 | 0.3 | 0.6 | 1.20 | 1.20 | 1.40 |
| 9-8 | 0.3 | 0.35 | 0.6 | 1.20 | 1.23 | 1.40 |
| 9-9 | 0.3 | 0.4 | 0.6 | 1.20 | 1.26 | 1.40 |
| 9-10 | 0.3 | 0.45 | 0.6 | 1.20 | 1.29 | 1.40 |
| 9-11 | 0.3 | 0.5 | 0.6 | 1.20 | 1.33 | 1.40 |
| 9-12 | 0.3 | 0.55 | 0.6 | 1.20 | 1.36 | 1.40 |
| 9-13 | 0.3 | 0.6 | 0.6 | 1.20 | 1.40 | 1.40 |
| 9-14 | 0.3 | 0.65 | 0.6 | 1.20 | 1.43 | 1.40 |
| 9-15 | 0.3 | 0.7 | 0.6 | 1.20 | 1.47 | 1.40 |
| 9-16 | 0.3 | 0.75 | 0.6 | 1.20 | 1.50 | 1.40 |
| 9-17 | 0.3 | 0.8 | 0.6 | 1.20 | 1.54 | 1.40 |
| 9-18 | 0.3 | 0.85 | 0.6 | 1.20 | 1.58 | 1.40 |
| 9-19 | 0.3 | 0.9 | 0.6 | 1.20 | 1.61 | 1.40 |
| 9-20 | 0.3 | 0.95 | 0.6 | 1.20 | 1.65 | 1.40 |
| 9-21 | 0.3 | 1.0 | 0.6 | 1.20 | 1.69 | 1.40 |

Here, samples 9-1 to 9-7 denote solar cells, each including a Cu(In,Ga)Se$_2$ layer with the above-mentioned double graded structure. Samples 9-8 to 9-13 denote solar cells where the bandgap of the Cu(In,Ga)Se$_2$ layer increases from the CdS layer side to the Mo layer side monotonically, and the first region and the second region are different from each other in the bandgap increase rate in a thickness direction of the Cu(In,Ga)Se$_2$ layer. In each of samples 9-8 to 9-13, the bandgap increase rate in the first region is larger than the bandgap increase rate in the second region. Sample 9-14 and the following samples are not included in the above-mentioned solar cells of the present invention, since G2 > G3.

Simulation was carried out in the same manner as in Example 1 for each of samples shown in Tables 10-14 so as to calculate values for short-circuit current density Jsc (mA/cm$^2$), an open-end voltage Voc (V), a fill factor (FF) and conversion efficiency (%). The results are shown in Tables 15-19.

(Table 15)

| Sample No. | Jsc (mA/cm$^2$) | Voc (V) | FF | Conversion Efficiency (%) |
|---|---|---|---|---|
| 5-1 | 40.2 | 0.617 | 0.621 | 15.4 |
| 5-2 | 39.7 | 0.633 | 0.659 | 16.5 |
| 5-3 | 39.0 | 0.649 | 0.692 | 17.5 |

Table continued

| Sample No. | Jsc (mA/cm$^2$) | Voc (V) | FF | Conversion Efficiency (%) |
|---|---|---|---|---|
| 5-4 | 38.4 | 0.666 | 0.719 | 18.4 |
| 5-5 | 37.6 | 0.681 | 0.740 | 19.0 |
| 5-6 | 36.7 | 0.695 | 0.756 | 19.3 |
| 5-7 | 35.6 | 0.706 | 0.767 | 19.3 |
| 5-8 | 34.2 | 0.716 | 0.774 | 18.9 |
| 5-9 | 32.8 | 0.723 | 0.779 | 18.5 |
| 5-10 | 31.0 | 0.728 | 0.781 | 17.6 |
| 5-11 | 28.6 | 0.731 | 0.784 | 16.4 |
| 5-12 | 25.9 | 0.733 | 0.785 | 14.9 |
| 5-13 | 23.4 | 0.735 | 0.787 | 13.5 |
| 5-14 | 21.3 | 0.736 | 0.789 | 12.4 |
| 5-15 | 19.8 | 0.737 | 0.791 | 11.6 |
| 5-16 | 18.7 | 0.738 | 0.793 | 10.9 |
| 5-17 | 17.8 | 0.740 | 0.795 | 10.5 |
| 5-18 | 17.0 | 0.741 | 0.797 | 10.1 |
| 5-19 | 16.4 | 0.742 | 0.799 | 9.7 |
| 5-20 | 15.8 | 0.744 | 0.800 | 9.4 |
| 5-21 | 15.3 | 0.745 | 0.801 | 9.1 |

(Table 16)

| Sample No. | Jsc (mA/cm$^2$) | Voc (V) | FF | Conversion Efficiency (%) |
|---|---|---|---|---|
| 6-1 | 39.9 | 0.620 | 0.620 | 15.4 |
| 6-2 | 39.4 | 0.637 | 0.662 | 16.6 |
| 6-3 | 38.8 | 0.655 | 0.698 | 17.7 |
| 6-4 | 38.2 | 0.673 | 0.729 | 18.7 |
| 6-5 | 37.5 | 0.690 | 0.753 | 19.5 |
| 6-6 | 36.6 | 0.707 | 0.770 | 19.9 |
| 6-7 | 35.6 | 0.721 | 0.783 | 20.1 |
| 6-8 | 34.5 | 0.733 | 0.791 | 20.0 |
| 6-9 | 33.5 | 0.742 | 0.796 | 19.8 |
| 6-10 | 31.9 | 0.750 | 0.799 | 19.1 |
| 6-11 | 30.0 | 0.755 | 0.800 | 18.1 |
| 6-12 | 27.6 | 0.758 | 0.801 | 16.7 |
| 6-13 | 24.9 | 0.760 | 0.800 | 15.1 |
| 6-14 | 22.3 | 0.761 | 0.802 | 13.6 |
| 6-15 | 20.4 | 0.762 | 0.803 | 12.5 |
| 6-16 | 19.0 | 0.764 | 0.804 | 11.7 |
| 6-17 | 17.9 | 0.765 | 0.806 | 11.1 |

Table continued

| Sample No. | Jsc (mA/cm$^2$) | Voc (V) | FF | Conversion Efficiency (%) |
|---|---|---|---|---|
| 6-18 | 17.1 | 0.767 | 0.807 | 10.6 |
| 6-19 | 16.3 | 0.768 | 0.808 | 10.1 |
| 6-20 | 15.7 | 0.770 | 0.809 | 9.8 |
| 6-21 | 15.2 | 0.771 | 0.810 | 9.5 |

(Table 17)

| Sample No. | Jsc Jsc (mA/cm$^2$) | Voc (V) | FF | Conversion Efficiency (%) |
|---|---|---|---|---|
| 7-1 | 39.6 | 0.624 | 0.608 | 15.0 |
| 7-2 | 39.1 | 0.641 | 0.655 | 16.4 |
| 7-3 | 38.5 | 0.659 | 0.696 | 17.7 |
| 7-4 | 37.9 | 0.679 | 0.731 | 18.8 |
| 7-5 | 37.2 | 0.698 | 0.759 | 19.7 |
| 7-6 | 36.4 | 0.716 | 0.779 | 20.3 |
| 7-7 | 35.5 | 0.733 | 0.793 | 20.6 |
| 7-8 | 34.5 | 0.748 | 0.803 | 20.7 |
| 7-9 | 33.7 | 0.761 | 0.808 | 20.7 |
| 7-10 | 32.5 | 0.770 | 0.812 | 20.3 |
| 7-11 | 31.0 | 0.777 | 0.813 | 19.6 |
| 7-12 | 29.1 | 0.783 | 0.813 | 18.5 |
| 7-13 | 26.6 | 0.786 | 0.813 | 17.0 |
| 7-14 | 23.8 | 0.788 | 0.811 | 15.2 |
| 7-15 | 21.3 | 0.789 | 0.811 | 13.7 |
| 7-16 | 19.5 | 0.790 | 0.812 | 12.5 |
| 7-17 | 18.2 | 0.792 | 0.813 | 11.7 |
| 7-18 | 17.2 | 0.793 | 0.813 | 11.1 |
| 7-19 | 16.4 | 0.795 | 0.814 | 10.6 |
| 7-20 | 15.7 | 0.796 | 0.814 | 10.2 |
| 7-21 | 15.1 | 0.798 | 0.815 | 9.8 |

(Table 18)

| Sample No. | Jsc Jsc (mA/cm$^2$) | Voc (V) | FF | Conversion Efficiency (%) |
|---|---|---|---|---|
| 8-1 | 39.3 | 0.627 | 0.575 | 14.2 |
| 8-2 | 38.7 | 0.645 | 0.631 | 15.7 |
| 8-3 | 38.2 | 0.663 | 0.681 | 17.3 |
| 8-4 | 37.6 | 0.683 | 0.723 | 18.6 |
| 8-5 | 36.9 | 0.704 | 0.757 | 19.6 |
| 8-6 | 36.1 | 0.724 | 0.781 | 20.4 |

Table continued

| Sample No. | Jsc Jsc (mA/cm$^2$) | Voc (V) | FF | Conversion Efficiency (%) |
|---|---|---|---|---|
| 8-7 | 35.3 | 0.743 | 0.799 | 20.9 |
| 8-8 | 34.4 | 0.761 | 0.810 | 21.2 |
| 8-9 | 33.6 | 0.777 | 0.817 | 21.4 |
| 8-10 | 32.7 | 0.790 | 0.821 | 21.2 |
| 8-11 | 31.6 | 0.799 | 0.823 | 20.8 |
| 8-12 | 30.2 | 0.807 | 0.823 | 20.0 |
| 8-13 | 28.1 | 0.812 | 0.822 | 18.8 |
| 8-14 | 25.4 | 0.815 | 0.820 | 17.0 |
| 8-15 | 22.7 | 0.816 | 0.818 | 15.1 |
| 8-16 | 20.3 | 0.818 | 0.817 | 13.6 |
| 8-17 | 18.6 | 0.819 | 0.817 | 12.5 |
| 8-18 | 17.4 | 0.821 | 0.817 | 11.7 |
| 8-19 | 16.4 | 0.823 | 0.817 | 11.0 |
| 8-20 | 15.7 | 0.824 | 0.817 | 10.6 |
| 8-21 | 15.0 | 0.826 | 0.817 | 10.1 |

(Table 19)

| Sample No. | Jsc (mA/cM$^2$) | Voc (V) | FF | Conversion Efficiency (%) |
|---|---|---|---|---|
| 9-1 | 38.8 | 0.631 | 0.512 | 12.5 |
| 9-2 | 38.4 | 0.649 | 0.579 | 14.4 |
| 9-3 | 37.8 | 0.667 | 0.643 | 16.2 |
| 9-4 | 37.2 | 0.687 | 0.699 | 17.9 |
| 9-5 | 36.5 | 0.708 | 0.743 | 19.2 |
| 9-6 | 35.8 | 0.730 | 0.776 | 20.3 |
| 9-7 | 34.9 | 0.751 | 0.798 | 20.9 |
| 9-8 | 34.2 | 0.772 | 0.813 | 21.4 |
| 9-9 | 33.5 | 0.791 | 0.822 | 21.8 |
| 9-10 | 32.7 | 0.807 | 0.827 | 21.8 |
| 9-11 | 31.8 | 0.820 | 0.830 | 21.6 |
| 9-12 | 30.7 | 0.830 | 0.830 | 21.1 |
| 9-13 | 29.1 | 0.837 | 0.829 | 20.2 |
| 9-14 | 26.9 | 0.842 | 0.827 | 18.7 |
| 9-15 | 24.3 | 0.845 | 0.824 | 16.9 |
| 9-16 | 21.6 | 0.847 | 0.821 | 15.0 |
| 9-17 | 19.4 | 0.848 | 0.819 | 13.4 |
| 9-18 | 17.7 | 0.850 | 0.818 | 12.3 |
| 9-19 | 16.6 | 0.852 | 0.817 | 11.5 |
| 9-20 | 15.7 | 0.854 | 0.816 | 10.9 |

Table continued

| Sample No. | Jsc (mA/cM$^2$) | Voc (V) | FF | Conversion Efficiency (%) |
|---|---|---|---|---|
| 9-21 | 15.0 | 0.855 | 0.816 | 10.4 |

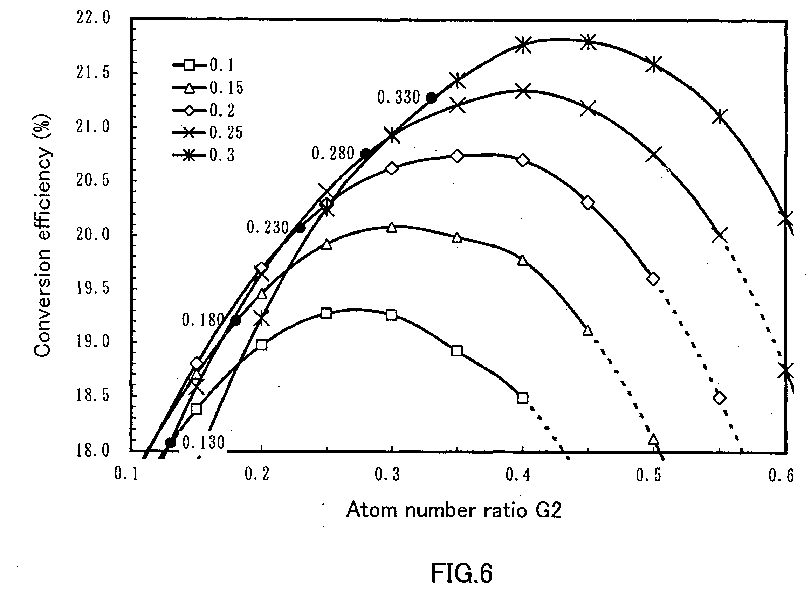

For clarifying the results as shown Tables 15-19, parts of the results in Tables 15-19 are shown in FIG. 6. FIG. 6 is drawn in a substantially same manner as FIG. 5.

It is shown in Tables 15-19 and FIG. 6, that a solar cell will have excellent conversion efficiency, when the solar cell includes a Cu(In,Ga)Se$_2$ layer whose bandgap increases from the CdS layer side to the Mo layer side monotonically, and when the bandgap increase rates of a first region and a second region in a direction of thickness of the Cu(In,Ga)Se$_2$ layer are different from each other, in comparison with a solar cell configured in a different manner (for example, including a Cu(In,Ga)Se$_2$ layer as a light-absorption layer with a single graded structure or a double graded structure). This effect was obtained when G1 was 0.1 or more (that is, the bandgap Eg1 was 1.08 eV or more). In a sample group where G3 was at least 0.45 (that is, Eg3 was at least 1.3 eV), the conversion efficiency exceeded 20%, and solar cells with more excellent conversion efficiency were obtained. Furthermore, when G1 was at least 0.3 (that is, the bandgap Eg1 was at least 1.2 eV), the number of samples whose conversion efficiencies was higher than 20% increased, and this indicates that solar cells with further excellent conversion efficiency would be obtained.

In a comparison between Example 1 and Example 2, a solar cell with more excellent conversion efficiency can be obtained when a difference between G1 and G3 is not 0.15 but 0.3 (that is, a difference between Eg1 and Eg3 is not about 0.09 eV but about 0.19 eV).

The present invention may be embodied in other forms without departing from the spirit or essential characteristics thereof. The embodiments disclosed in this application are to be considered in all respects as illustrative and not limiting. The scope of the invention is indicated by the appended claims rather than by the foregoing description, all changes that come within the meaning and range of equivalency of the claims are intended to be embraced therein.

Industrial Applicability

As mentioned above, the present invention can realize a solar cell including a light-absorption layer of a compound semiconductor with a chalcopyrite structure, and having excellent characteristics such as conversion efficiency. The solar cell of the present invention includes a light-absorption layer having a novel band profile different from that according to a conventional technique. With use of the light-absorption layer having the novel band profile, further improvement in reliability and characteristics can be expected.

**Claims**

1. A solar cell comprising: a first electrode layer, a second electrode layer, a p-type semiconductor layer interposed between the first electrode layer and the second electrode layer, and a n-type semiconductor layer interposed between the p-type semiconductor layer and the second electrode layer,
   the p-type semiconductor layer comprising a compound semiconductor that contains a group Ib element, a group IIIb element and a group VIb element and that has a chalcopyrite structure,
   the p-type semiconductor layer having a bandgap that increases from the n-type semiconductor side to the first electrode layer side monotonically,
   a bandgap of the p-type semiconductor layer on the main surface at the n-type semiconductor layer side being at least 1.08 eV,
   a bandgap of the p-type semiconductor layer on the main surface at the first electrode layer side being at least 1.17 eV, and
   in the p-type semiconductor layer, a first region at the n-type semiconductor layer side and a second region at the first electrode layer side being different from each other in bandgap increase rate in a direction of thickness of the p-type semiconductor layer.

2. The solar cell according to claim 1, wherein the bandgap of the p-type semiconductor layer on the main surface at the n-type semiconductor layer side is at least 1.2 eV

3. The solar cell according to claim 1, wherein the bandgap of the p-type semiconductor layer on the main surface at the first electrode layer side is at least 1.3 eV

4.  The solar cell according to claim 1, wherein the bandgap increase rate in the second region is smaller than the bandgap increase rate in the first re gion.

5.  The solar cell according to claim 1, wherein the group Ib element is Cu, the group IIIb element is at least one element selected from the group consisting of In, Ga and Al, and the group VIb element is at least one element selected from the group consisting of Se and S.

6.  The solar cell according to claim 1, wherein the group IIIb element is at least one element selected from the group consisting of In, Ga and Al, and
    a content of the at least one element in the p-type semiconductor layer changes in a direction of thickness of the p-type semiconductor layer.

7.  The solar cell according to claim 6, wherein
    the group IIIb elements comprise Ga,
    an atom number ratio of Ga to the group IIIb elements in the p-type semiconductor layer increases from the n-type semiconductor layer side to the first electrode layer side monotonically, and
    in the p-type semiconductor layer, the first region at the n-type semiconductor layer side and the second region at the first electrode layer side are different from each other in the atom number ratio in a direction of thickness of the p-type-semiconductor layer.

8.  The solar cell according to claim 7, wherein the increase rate of the atom number ratio in the second region is smaller than the increase rate of the atom number ratio in the first region.

9.  The solar cell according to claim 6, wherein
    the group IIIb elements comprise Al,
    an atom number ratio of Al to the group IIIb elements in the p-type semiconductor layer increases from the n-type semiconductor layer side to the first electrode layer monotonically,
    in the p-type semiconductor layer, the first region at the n-type semiconductor layer side and the second region at the first electrode layer side are different from each other in the atom number ratio in a direction of thickness of the p-type semiconductor layer, and
    the first region at the window layer side and the second region at the first electrode layer side in the semiconductor layer are different from each other in the increase rate of the atom number ratio.

10. The solar cell according to claim 9, wherein the increase rate of the atom number ratio in the second region is smaller than the increase rate of the atom number ratio in the first region.

11. The solar cell according to claim 7, wherein the atom number ratio of the p-type semiconductor layer on the main surface at the n-type semiconductor layer side is at least 0.1, and
    the atom number ratio of the p-type semiconductor layer on the main surface at the first electrode layer side is at least 0.25.

12. The solar cell according to claim 11, wherein the atom number ratio of the p-type semiconductor layer on the main surface at the n-type semiconductor layer side is at least 0.3.

13. The solar cell according to claim 11, wherein the atom number ratio of the p-type semiconductor layer on the main surface at the first electrode layer side is at least 0.45.

FIG. 1

FIG. 2A

Double graded structure

FIG. 2B

FIG. 3

FIG. 4

FIG.5

FIG.6

EP 1 619 728 A1

**INTERNATIONAL SEARCH REPORT**

| International application No. |
| --- |
| PCT/JP2004/005125 |

**A. CLASSIFICATION OF SUBJECT MATTER**
Int.Cl⁷ H01L31/072, H01L31/032

According to International Patent Classification (IPC) or to both national classification and IPC

**B. FIELDS SEARCHED**

Minimum documentation searched (classification system followed by classification symbols)
Int.Cl⁷ H01L31/00-31/078

Documentation searched other than minimum documentation to the extent that such documents are included in the fields searched

| | | | |
| --- | --- | --- | --- |
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | M. Contreras et al., "High Efficiency Cu(In, Ga) Se2-Based Solar Cells: Processing of Novel Absorber Structures", First WCPEC (World Conference on Photovoltaic Energy Conversion); December, 5-9, 1994, Hawaii, pp.68 to 75 | 1-13 |
| Y | K. KUSHIYA et al., "Development of Polycrystalline CuInxGal-xSe2 Thin-Film Solar Cells with Band Gap of 1.3 to 1.5 eV", Japanese Journal of Applied Physics, Part 1, No.12A, Vol.33, (1994). pages 6599 to 6604 | 1-13 |
| Y | T. NEGAMI et al., "Production technology for CIGS thin film solar cells", Thin Solid Films, 403-404(2002), pages 197 to 203 | 1-13 |

☒ Further documents are listed in the continuation of Box C.    ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 21 June, 2004 (21.06.04) | 06 July, 2004 (06.07.04) |

| Name and mailing address of the ISA/ | Authorized officer |
| --- | --- |
| Japanese Patent Office | |
| Facsimile No. | Telephone No. |

Form PCT/ISA/210 (second sheet) (January 2004)

| INTERNATIONAL SEARCH REPORT | | International application No. |
|---|---|---|
| | | PCT/JP2004/005125 |

C (Continuation).  DOCUMENTS CONSIDERED TO BE RELEVANT

| Category* | Citation of document, with indication, where appropriate, of the relevant passages | Relevant to claim No. |
|---|---|---|
| Y | T. Dullweber et al., "Study of the effect of gallium grading in Cu(In, Ga)Se2", Thin Solid Films, 361-362(2000), pages 478 to 481 | 1-13 |
| Y | JP 9-213977 A  (Matsushita Electric Industrial Co., Ltd.), 15 August, 1997 (15.08.97), (Family: none) | 1-13 |
| Y | JP 11-274526 A  (Yazaki Corp.), 08 October, 1999 (08.10.99), (Family: none) | 1-13 |
| Y | A. Dhingra et al., "Computer Simulation and Modeling of Graded Bandgap CuInSe2/CdS Based Solar Cells", IEEE Transactions on Electron Devices, Vol.43, No.4, 1996, pages 613 to 621 | 1-13 |

Form PCT/ISA/210 (continuation of second sheet) (January 2004)